# EUROPÄISCHE PATENTSCHRIFT

(11) **EP 1 318 623 B1**
(45) Veröffentlichungstag und Bekanntmachung des Hinweises auf die Patenterteilung: **15.02.2006**
(21) Anmeldenummer: 02023325.0
(22) Anmeldetag: 18.10.2002
(51) Int. Cl.: H04B 17/00

(54) **Verfahren zur Gewinnung einer Feldstärkeinformation**
Method for obtaining field strength information
Méthode pour détecter l'intensité d'un champs électromagnétique

(30) Priorität: 05.12.2001 DE 10159551
(43) Veröffentlichungstag der Anmeldung: 11.06.2003
(73) Patentinhaber: ATMEL Germany GmbH, 74072 Heilbronn (DE)
(72) Erfinder: Blatz, Werner, Dipl.-Ing. (FH), 74211 Leingarten (DE); Moser, Helmut, 74078 Heilbronn (DE)

(56) Entgegenhaltungen:
- DE-A1- 19 753 186
- DE-A1- 19 852 525
- DE-C1- 19 637 357
- US-A- 4 975 686

## Beschreibung

Die vorliegende Erfindung betrifft ein Verfahren zur Gewinnung einer Feldstärkeinformation, gemäß dem Oberbegriff des Patentanspruchs 1.

Ein derartiges Verfahren ist aus der Druckschrift "Datenbuch ATMEL 2001 S. 233" bekannt Hierbei wird mittels eines sogenannten "RSSI-(Received Signal Strength Indicator)-Verstärkers" eine Ausgangsspannung erzeugt, die zu dem Eingangssignal einer Empfangsantenne proportional ist. Die Ausgangsspannung stellt damit ein Maß für die empfangene Feldstärke dar. Dies wird im Allgemeinen durch eine Kaskadierung von einzelnen Verstärkerstufen erreicht, von denen mit steigender Eingangssignalhöhe immer mehr Stufen in Sättigung gesteuert werden. Aus dem Summenwert der Ausgangsströme der Verstärkerstufen läßt sich ein der Feldstärke des empfangenen Signals proportionales Signal ableiten. Nachteilig bei Verwendung von RSSI-Verstärkern ist die hohe Stromaufnahme des Verfahrens. Ferner weisen derartige Verstärker gerade bei schnell wechselnden Eingangssignalhöhen lange An- und Abschwingzeiten auf, welche insbesondere bei Puls-Pausen modulierten Signalen erforderlich macht die Länge der Feldlücke an die maximal erreichbare Amplitudenhöhe im Eingangssignal anzupassen, um eine sichere Datenübertragung zu gewährleisten. Hierdurch wird die Datenrate erheblich verringert.

Ein weiteres Verfahren zur Gewinnung einer Feldstärke information unter Verwendung eines Eingangswiderstandes für eine Operationsverstärkerschaltung ist aus der DE 197 53 186 A bekannt.

Verfahren zur Gewinnung einer Feldstärkeinformation werden unter anderem bei Systemen für eine kontaktlose Datenübertragung verwendet. Ein wichtiger Anwendungsbereich stellen Identifikationssysteme dar, die beispielsweise in einem Kraftfahrzeug bei der Zugangskontrolle eingesetzt werden. Derartige Identifikationssysteme bestehen aus einer Basiseinheit und einem oder mehreren Transpondern. Hierbei läßt sich mittels der Feldstärkeinformation eine Entfernungsbestimmung zwischen Sender und Empfänger durchführen und die Sicherheit bei der Datenübertragung gegen eine unbefugte Weiterleitung erhöhen. Aufgabe der vorliegenden Erfindung ist es, ein Verfahren anzugeben, mittels der sich die Feldstärke eines Eingangssignal bestimmen läßt. Weitere Aufgabe der vorliegenden Erfindung ist es eine Schaltungsanordnung zur Durchführung des Verfahrens anzugeben.

Die genannte Aufgabe wird durch die Merkmale des Patentanspruches 1 gelöst. Die zweitgenannte Aufgabe wird durch die Merkmale des Patentanspruches 6 gelöst. Günstige Ausgestaltungsformen sind Gegenstand von Unteransprüchen.

Das Wesen der Erfindung besteht darin, daß die Feldstärke eines elektromagnetischen Signals aus der Größe eines Eingangswiderstandes bestimmt wird. Hierzu wird bei dem empfangenen elektromagnetischen Signal, bei dem in einer Empfangseinheit aus dem empfangenen Signal mittels des Eingangswiderstands eine Eingangsspannung für einen Operationsverstärker, der einen festen Verstärkungsfaktor aufweist, erzeugt und das Verhältnis von Eingangsspannung zu Ausgangsspannung bestimmt, die Ausgangsspannung des Operationsverstärkers mit einer Referenzspannung verglichen. Des Weiteren wird die Eingangsspannung des Operationsverstärkers mittels einer Änderung des Eingangswiderstands geändert, bis die Ausgangsspannung innerhalb eines vorgegebenen Intervalls um die Referenzspannung liegt. Nachfolgend wird durch einen Vergleich des Wertes des geänderten Eingangswiderstandes mit Werten, die in einem Wertefeld abgelegt sind, dem empfangenen Signal ein Feldstärkewert zugeordnet.

Ein Vorteil des Verfahrens ist es, daß sich auf einfache Weise aus der Höhe des Widerstandswertes die Feldstärke des empfangenen elektromagnetischen Signals bestimmen läßt. Hierbei wird der Eingangswiderstand erhöht bzw. erniedrigt, wenn die Ausgangsspannung des Operationsverstärkers unterhalb bzw. oberhalb des durch das Intervall gegebenen Spannungsbereiches liegt Da die Verstärkung des Operationsverstärkers konstant bleibt, weist die Ausgangsspannung des Operationsverstärkers zur Eingangsspannung ein festes Verhältnis auf. Hierdurch wird weder bei kleinen noch bei großen Eingangsspannungen die Verstärkung erhöht und das Verhältnis von Signalspannung zu Rauschspannung bleibt im gesamten Verstärkungsbereich gering. Ferner wird insbesondere bei wechselnden Signalhöhen ein schnelles An- und Abschwingen am Ausgang des Operationsverstärkers erreicht, da die Ausgangsspannung und die Eingangsspannung des Operationsverstärkers nur wenig schwankt und die am Eingang bzw. Ausgang des Operationsverstärkers vorhandenen Kapazitäten nicht umgeladen und der Stromverbrauch wird verringert. Insbesondere bei Puls-Pausen modulierten Signalen läßt durch das kurze An- und Abschwingen die Feldlücke verringern und die Datenrate erhöhen. Ein weiterer Vorteil des festen Verstärkungsfaktors ist es, daß bei dem Operationsverstärker mittels einer hochohmigen Gegenkopplung die Verstärkung präzise mit einer geringen Stromaufnahme einstellbar ist.

In einer Weiterbildung des Verfahrens wird der Eingangswiderstand in diskreten Stufen geändert. Hierbei läßt sich der Schaltungsaufwand zur Änderung des Eingangswiderstandes im Vergleich zu einer gleitenden Änderung des Eingangswiderstandes wesentlich reduzieren. Ferner ist es vorteilhaft, die Eingangsspannung dem Operationsverstärker von einem Teilerknoten als Spannungsteiler ausgebildeten Eingangswiderstands zuzuführen und hierbei den Widerstandswert des mit einem Bezugspotential verbundenen Teils des Spannungsteilers zu ändern. Durch die passive Ausführung mittels Widerständen läßt sich die Eingangsspannung des Operationsverstärkers weitestgehend konstant halten, ohne die geringe Stromaufnahme des Eingangskreises zu verändern. Des Weiteren läßt sich das Verfahren zur Bestimmung des räumlichen Abstandes zwischen der Empfangseinheit und einer Sendeeinheit verwenden, indem die in der Wertetabelle dem jeweiligen Widerstandswert zugeordneten Feldstärkewerte mit einem Abstandswert verknüpft wird. Hierbei läßt sich mit den Werten aus der Wertetabelle ein Entfernungsbereich, bei dem eine Datenübertragung zugelassen ist, festlegen. Ferner läßt sich die Datenrate mit der Verkleinerung der Feldlücke erhöhen. Des Weiteren ist das Verfahren durch den geringen Stromverbrauch besonders geeignet, um bei Transpondern eine Feldstärkeinformation zu gewinnen.

Das erfindungsgemäße Verfahren soll nachfolgend anhand der Ausführungsbeispiele im Zusammenhang mit den schematisierten Zeichnungen erläutert werden. Es zeigen,
- Fig. 1: eine Verstärkerschaltung mit einem Spannungsteiler am Eingang bei der mittels eines Stellgliedes der Widerstandswert des Spannungsteilers verändert wird,
- Fig. 2: einen Spannungsteiler, dessen Widerstandswert mittels des Stellgliedes diskret verändert wird,
- Fig. 3: eine Ausführungsform des Spannungsteilers mit gesteuerten Transistoren, und
- Fig. 4: eine weitere Ausführungsform des Spannungsteilers mit gewichteten Stromquellen.

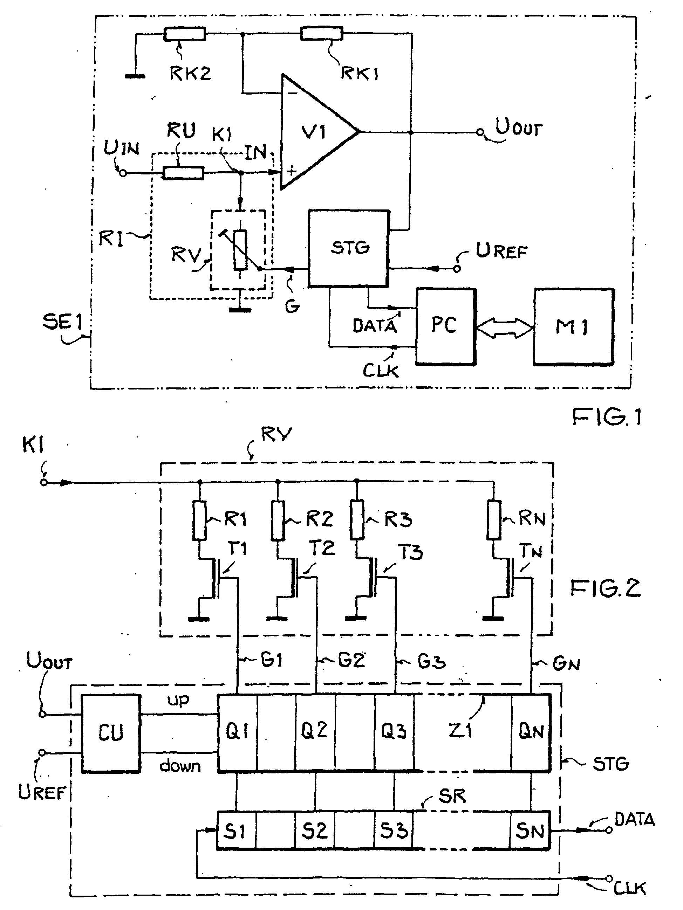

Die Aufgabe der in Figur 1 dargestellten Schaltungsanordnung ist es, ein wechselspannungsförmiges Eingangssignal UIN, das proportional der Feldstärke eines von einer Empfangsantenne (nicht abgebildet) empfangenen elektromagnetischen Signals ist, mittels eines Operationsverstärkers V1 um einen festen Faktor zu verstärken und hierbei das Ausgangssignal UOUT mittels eines Stellgliedes STG, das den Widerstandswert eines als Spannungsteiler ausgebildeten Eingangswiderstands RI verändert, innerhalb eines vorgegebenen Intervalls zu halten und dem Widerstandswert eine Feldstärkeinformation zuzuordnen. Im Folgenden wird die Schaltungsanordnung näher erläutert.

Der Spannungsteiler besteht aus einem Widerstand R1 und einem mit einem Bezugspotential verschalteten steuerbaren Widerstand RV. Ferner weist der Spannungsteiler einen Knoten K1 auf, der mit dem nichtinvertierenden Eingang des Operationsverstärker V1 verbunden ist.

Des Weiteren liegt an dem Ausgang des Operationsverstärkers V1 die Ausgangsspannung UOUT an. Der Ausgang des Operationsverstärkers V1 ist mit einem Widerstand RK1 und mit dem Stellglied STG verbunden. Ferner ist der Widerstand RK1 mit dem invertierenden Eingang des Operationsverstärkers und mit einem Widerstand RK2, der mit dem Bezugspotential verbunden ist, verschaltet. Des Weiteren ist das Stellglied STG mittels einer Steuerleitung G mit dem Steuereingang des Widerstandes RV, sowie mittels einer Leitung CLK und einer Leitung DATA mit einem Prozessor PC verschaltet. Ferner weist das Stellglied einen Eingang auf an dem eine Spannung UREF anliegt. Der Prozessor PC ist seinerseits mit einer Speichereinheit M1 verbunden.
Im Folgenden wird die Funktionsweise erläutert. Dem Operationsverstärker V1 wird die Spannung IN aus dem Eingangssignal UIN mittels des Widerstandes R1 zugeführt, wobei die Spannungshöhe an dem Knoten K1 durch den Widerstand RV bestimmt wird. Hierbei wird die Verstärkung des Operationsverstärkers V1 durch die beiden Widerstände RK1 und RK2 mittels denen das Potential des invertierenden Eingangs eingestellt wird, bestimmt. Untersuchungen der Anmelderin haben gezeigt, daß es besonders vorteilhaft ist, wenn für beide Widerstände RK1 und RK2 hochohmige Werte verwendet werden, mittels denen sich die Verstärkung präzise einstellen und gleichzeitig die Stromaufnahme der Schaltungsanordnung reduzieren läßt. Ferner wird mittels der am Stellglied STG anliegende Referenzspannung UREF im Stellglied STG ein Spannungsintervall erzeugt, daß um die Referenzspannung UREF liegt. Liegt die Ausgangsspannung UOUT oberhalb des Spannungsintervall wird von dem Stellglied STG mittels der Steuerleitung G der Widerstandswert des Widerstandes RV verringert. Liegt die Ausgangsspannung UOUT unterhalb des Spannungsintervalls wird von dem Stellglied STG der Widerstandswert des Widerstandes RV erhöht. Ferner wird der von dem Stellglied STG eingestellte Widerstandswert mittels der Datenleitung DATA an den Prozessor PC mitgeteilt, wobei das Auslesen der Daten mittels der Taktleitung CLK von dem Prozessor synchronisiert wird. Nachfolgend bestimmt der Prozessor PC die Höhe der Eingangsspannung mittels des Vergleichs des Wertes des Widerstandes RV mit dem in der Speichereinheit MEM abgelegten Widerstandswert dem eine Feldstärkeinformation zugeordnet ist.

Ein Vorteil der Anordnung ist es, daß durch die Änderung des Eingangswiderstandes in Verbindung mit dem festen Verstärkungsfaktor die Spannungshöhen an dem Eingang und an dem Ausgang des Operationsverstärkers auch bei stark schwankenden Eingangssignalen bzw. Feldstärken sich nur wenig ändern. Vorhandene Kapazitäten am Ausgang und Eingang des Operationsverstärkers werden hierdurch schneller umgeladen und die Schaltungsanordnung weist geringe An- und Abschwingzeiten auf. Durch die Anpassung der Schaltungsanordnung mittels des Spannungsteilers an die Höhe des Eingangssignals, weist die Schaltungsanordnung eine geringe Stromaufnahme auf. Hierdurch wird bei Anwendung in einem Transponder die Batterie weniger schnell entladen. Ferner lassen sich die Feldlücken beispielsweise bei einer 125 KHz Schwingung verringern und die Datenrate erhöhen.

In der Figur 2 ist ein Ausführungsbeispiel für den Widerstand RV und das Stellglied STG dargestellt. Für die äußere Beschaltung des Widerstandes RV und des Stellgliedes STG gelten die in Zusammenhang mit der Figur 1 gemachten Erläuterungen. Im Folgenden wird der Aufbau der Schaltungsanordnung näher erläutert. Der Widerstand RV weist mehrere aus gleichartigen Bauteilen bestehenden Schaltungszweige auf. Alle Schaltungszweige des Widerstandes RV sind gemeinsam mit dem Knoten K1 jedoch einzeln mit dem Stellglied STG verschaltet und mittels eines Schaltelementes, beispielsweise einem Transsitor, das in den einzelnen Schaltungszweig integriert ist, an- oder ausgeschaltet. Nachfolgend wird ein erster Schaltungszweig stellvertretend für die weiteren Schaltungszweige erläutert. Der erste Schaltungszweig weist eine Reihenschaltung aus einem Widerstand R1, der mit dem Knoten K1 verschaltet ist, und einen Transistor T1, der mit dem Bezugspotential verschaltet ist, auf. Hierbei ist der Steuereingang des Transistors T1 mit einem Ausgang G1 des Stellgliedes STG verbunden. Die Anzahl der Schaltungszweige und die Werte der einzelnen Widerstände R1 bis RN bestimmt sich aus der Größe des Bereiches, in dem das Potential am Knoten K1 verändert wird. Ferner bestimmt die Anzahl der Schaltungszweige des Widerstandes RV die Anzahl der Ausgänge G1 bis GN des Stellgliedes STG.
Das Stellglied STG weist eine Steuereinheit CU mit einem ersten Eingang, der mit der Ausgangsspannung UOUT, und einen zweiten Eingang, der mit der Referenzspannung UREF verschaltet ist, auf. Ferner weist die Steuereinheit einen ersten Ausgang UP und einen zweiten Ausgang DOWN auf, die mit einer Schaltungseinheit Z1 verbunden sind. Die Schaltungseinheit Z1 weist einzelnen Schaltblöcken Q1 bis QN auf, die mit dem Steuerausgang G1 bis GN verschaltet sind, auf. Ferner ist jeder dieser Schaltblöcke Q1 bis QN mit einem Block S1 bis SN eines Schieberegisters SR verbunden. Das Schieberegister seinerseits ist mit der Taktleitung CLK und mit der Datenleitung DATA verschaltet.
Im Folgenden wird die Funktionsweise erläutert. Die Steuereinheit CU verändert den Wert des steuerbaren Widerstandes RV, sofern die Ausgangsspannung UOUT .außerhalb des durch die Referenzspannung UREF gegebenen Bereichs liegt, indem sie mittels der Ausgänge UP und DOWN die Schaltblöcke Q1 bis QN ansteuert. Wird beispielsweise der Schaltungsblock Q1 durch das Signal UP angesteuert, wird mittels des Ausgangs G1 der Transistor T1 leitend. Hierdurch wird der Widerstand R1 mit dem Bezugspotential verbunden und der Wert des Widerstandes RV erniedrigt. Wird der Schaltungsblock Q1 mit dem Signal DOWN angesteuert, wird der Transistor T1 gesperrt und der Wert des Widerstandes RV erhöht. Jede Änderung des Zustands des Schaltungsblocks Q1 wird in dem Block S1 als digitale Information abgespeichert. Die anderen Schaltungszweige des Widerstandes RV werden mittels den Ausgängen G2- GN angesteuert. Werden alle Schaltungszweige des Widerstandes RV mit dem Bezugspotential verbunden weist der Widerstand RV seinen kleinsten Wert auf. Durch eine geeignete Wahl der Werte der Widerstände R1 bis RN läßt sich eine digitale Kodierung des Eingangssignals UIN durchführen. Die in den einzelnen Blöcken S1 bis SN des Schieberegisters SR gespeicherte Information des Zustandes des jeweiligen Schaltungszweiges und hierdurch den Wert des Widerstandes RV bzw. die Höhe des Eingangssignals UIN läßt sich von dem Prozessor PC über die Leitung DATA auslesen.

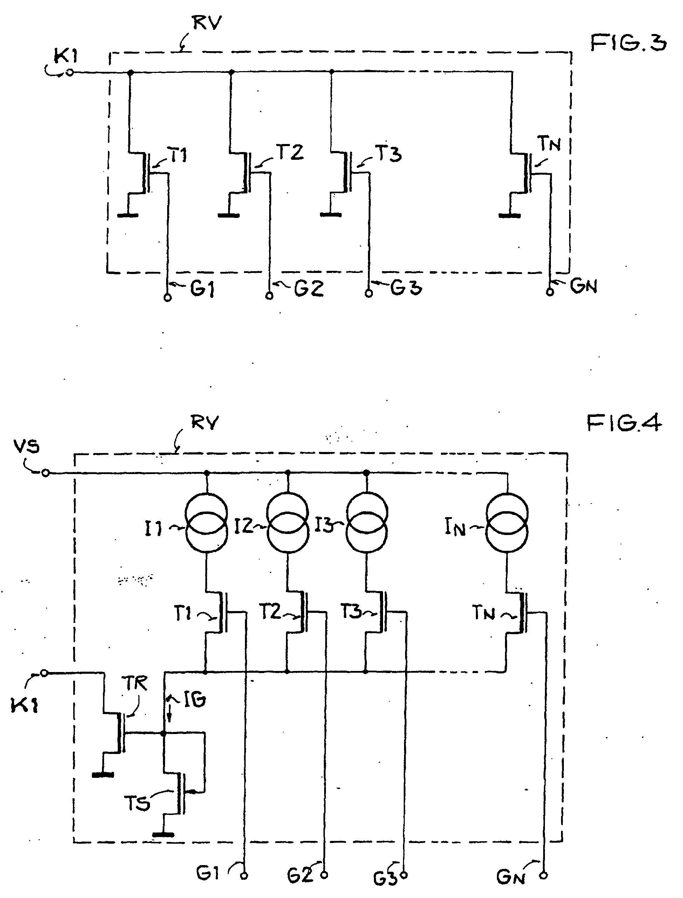

In der Figur 3 ist eine weitere Ausführungsform des gesteuerten Widerstandes RV dargestellt. Hierbei entfällt, im Unterschied zu der Ausführungsform dargestellt in der Figur 2, der Widerstandes R1 bis RN des jeweiligen Schaltungszweigs, d.h. der Widerstand des einzelnen Schaltungszweigs wird durch den Transistor T1 bis TN bestimmt, wobei der Sättigungswiderstand oder die Höhe der Ansteuerspannung des Transistors T1 bis TN die Größe des Widerstandswertes des Schaltungszweiges bestimmt. Mit einem vorgegebenen Größenverhältnis der Transistoren T1 - TN läßt sich auf einfache Weise eine Kodierung des Eingangssignals bzw. der Feldstärke durchführen.

Bei der in der Figur 4 dargestellten Ausführungsform des gesteuerten Widerstandes RV, weisen die einzelnen Schaltungszweige Stromquellen Q1 bis QN auf, die gemeinsam mit einer Versorgungsspannung VS verschaltet sind. In den nachfolgenden Erläuterungen wird auf die Ausführungen in dem Zusammenhang mit der Figur 2 Bezug genommen. Die einzelnen Stromquellen Q1 bis QN werden mittels den Transistoren T1 bis TN mit der Leitung IG verbunden, sofern die Transistoren T1 bis TN angesteuert werden. Die Leitung IG trägt hierdurch immer den Summenstrom der Stromquellen I1 bis IN der Schaltungszweige, deren Transistoren angesteuert werden. Ferner ist die Leitung IG mit einem als Diode verschalteten Transistor TS und mit dem Steuereingang eines Transistors TR verbunden ist. Ferner ist der Transistor TS mit dem Bezugspotential verschaltet. Des Weiteren ist der Transistor TR mit dem Knoten K1 und mit dem Bezugspotential verschaltet. Die Transistoren TR und TS bilden in der vorliegenden Anordnung einen Stromspiegel, d.h. je höher der Summenstrom auf der Leitung IG ist, desto höher wird der Spannungsabfall an dem Transistor TS und hierdurch die Ansteuerspannung an dem Steuereingang des Transistors TR. Damit wird der Widerstand des Transistors TR und der Wert des Widerstands RV erniedrigt.

In den bisher angeführten Ausführungsbeispielen lassen sich die dargestellten MOS-Transistoren durch Bipolartransistoren ersetzen. Nachteilig ist, daß die Ausführungsform mit Bipolartransistoren eine erhöhte Stromaufnahme aufweist.

## Patentansprüche

1. Verfahren zur Gewinnung einer Feldstärkeinformation mittels einer Empfangseinheit (SE1) aus einem empfangenen elektromagnetischen Signal, bei dem in der Empfangseinheit aus dem empfangenen Signal (UIN) mittels eines Eingangswiderstands (RI) eine Eingangsspannung (IN) für einen Operationsverstärker (V1), der einen festen Verstärkungsfaktor aufweist, erzeugt und das Verhältnis von Eingangsspannung (IN) zu Ausgangsspannung (UOUT) bestimmt wird,
**dadurch gekennzeichnet, daß**
• die Ausgangsspannung (UOUT) des Operationsverstärkers (V1) mit einer Referenzspannung (UREF) verglichen wird, und
• die Eingangsspannung (IN) des Operationsverstärkers (V1) mittels einer Änderung des Eingangswiderstands (RI) geändert wird, bis die Ausgangsspannung (UOUT) innerhalb eines vorgegebenen, den Wert der Referenzspannung (UREF) einschließenden Intervalls liegt, und
• durch einen Vergleich des Wertes des geänderten Eingangswiderstandes (RI) mit Werten, die in einem Wertefeld abgelegt sind, dem empfangenen Signal ein Feldstärkewert zugeordnet wird.

2. Verfahren nach Anspruch 1, **dadurch gekennzeichnet, daß** der Eingangswiderstand (RI) in diskreten Stufen geändert wird.

3. Verfahren nach Anspruch 1 oder Anspruch 2, **dadurch gekennzeichnet, daß** die Eingangsspannung (IN) dem Operationsverstärker (V1) von einem Teilerknoten (K1) des als Spannungsteiler ausgebildeten Eingangswiderstands (RI) zugeführt wird.

4. Verfahren nach Anspruch 3, **dadurch gekennzeichnet, daß** der Widerstandswert des mit einem Bezugspotential verbundenen Teils (RV) des Spannungsteilers geändert wird.

5. Verwendung des Verfahrens nach einem der Ansprüche 1 bis 4 zur Bestimmung des räumlichen Abstandes zwischen der Empfangseinheit und einer Sendeeinheit.

6. Schaltungsanordnung zur Durchführung des Verfahrens nach einem der Ansprüche 1 bis 4 mit einem Signaleingang (UIN) und einem Signalausgang (UOUT), einem Operationsverstärker (V1), der einen ersten Eingang, einen zweiten Eingang und einen Ausgang aufweist, einer Prozessoreinheit (PC) und einer Speichereinheit (M1), die mit der Prozessoreinheit (PC) verbunden ist, wobei
• zur Festlegung der Verstärkung der erste Eingang des Operationsverstärkers mit dem Teilerknoten eines ersten Spannungsteilers (RK1, RK2) verschaltet ist und ein erster Anschluß des Spannungsteilers mit dem Ausgang und ein zweiter Anschluß des Spannungsteilers (RK1, RK2) mit einem Bezugspotential verschaltet ist,
• der zweite Eingang des Operationsverstärkers mit dem Teilerknoten eines zweiten Spannungsteilers (R1, RV) verschaltet ist, und der zweite Spannungsteiler als Serienschaltung eines ersten mit dem Signaleingang verbundenen Widerstandes (R1) und eines zweiten mit dem Bezugspotential verbundenen steuerbaren Widerstands (RV) ausgebildet ist,
• der Ausgang des Operationsverstärkers (V1) mit dem Signalausgang (UOUT) verbunden ist,
**dadurch gekennzeichnet, daß**
• ein mit einer Referenzspannung (UREF) verschaltetes Stellglied (STG) mit dem Ausgang des Operationsverstärkers (V1) verbunden ist, und
• das Stellglied (STG) mit dem Steuereingang (G) des zweiten Widerstandes (RV) verschaltet ist, und
• das Stellglied (STG) einen mit der Prozessoreinheit (PC) verschalteten Datenausgang (DATA) und einen mit der Prozessoreinheit (PC) verschalteten Takteingang (CLK) aufweist.

7. Schaltungsanordnung nach Anspruch 6, **dadurch gekennzeichnet, daß** der steuerbare Widerstand (RV) aus wenigstens zwei parallelen Schaltungszweigen gebildet ist und jeder Schaltungszweig als Reihenschaltung von einem Widerstand (R1 - RN) und einem steuerbaren Schaltelement (T1 - TN) ausgebildet ist, und der Steuereingang eines jeden Schaltelementes (T1- TN) mit jeweils einem Steuerausgang (G1 - GN) des Stellgliedes (STG) verschaltet ist.

8. Schaltungsanordnung nach Anspruch 6, **dadurch gekennzeichnet, daß** der steuerbare Widerstand (RV) aus wenigstens zwei parallelen Schaltungszweigen besteht und jeder Schaltungszweig als Transistor (T1-TN) ausgeführt ist, und der Steuereingang eines jeden Transistors (T1- TN) mit jeweils einem Steuerausgang (G1 - GN) des Stellgliedes (STG) verschaltet ist.

9. Schaltungsanordnung nach Anspruch 6, **dadurch gekennzeichnet, daß** der steuerbare Widerstand (RV) aus wenigstens zwei parallelen Schaltungszweigen gebildet ist und jeder Schaltungszweig als eine Reihenschaltung von einer steuerbaren Stromquelle (I1 - IN) und einem steuerbaren Schaltelement (T1 - TN) ausgebildet ist, und der Steuereingang eines jeden Schaltelement (T1 -TN) mit jeweils einem Steuerausgang (G1 - GN) des Stellgliedes (STG) verschaltet ist.

10. Schaltungsanordnung nach Anspruch 7 oder Anspruch 9, **dadurch gekennzeichnet, daß** das Schaltelement (T1 - TN) als Transistor, vorzugsweise als ein MOS Transistor, ausgeführt ist.

## Claims

1. Method of obtaining field strength information by means of a receiving unit (SE1) from a received electromagnetic signal, in which an input voltage (IN) for an operational amplifier (V1) having a fixed amplification factor is produced in the receiving unit from the received signal (UIN) by means of an input resistance (R1) and the ratio of input voltage (IN) to output voltage (UOUT) is determined, **characterised in that**
- the output voltage (UOUT) of the operational amplifier (V1) is compared with a reference voltage (UREF),
- the input voltage (IN) of the operational amplifier (V1) is varied by means of changing the input resistance (R1) until the output voltage (UOUT) lies within a predetermined interval surrounding the value of the reference voltage (UREF) and
- a field strength value is assigned to the received signal through comparison of the value of the changed input resistance (R1) with values filed in a values field.

2. Method according to claim 1, **characterised in that** the input resistance (R1) is changed in discrete steps.

3. Method according to claim 1 or claim 2, **characterised in that** the input voltage (IN) is fed to the operational amplifier (V1) from a divider junction (K1) of the input resistance (R1), which is constructed as a voltage divider.

4. Method according to claim 3, **characterised in that** the resistance value of the part (RV), which is connected with a reference potential, of the voltage divider is varied.

5. Use of the method according to one of claims 1 to 4 for determining the physical spacing between the receiving unit and a transmitting unit.

6. Circuit arrangement for carrying out the method according to one of claims 1 to 4, with a signal input (UIN) and a signal output (UOUT), an operational amplifier (V1), which has a first input, a second input and an output, a processor unit (PC) and a memory unit (M1), which is connected with the processor unit (PC), wherein
- for establishing the amplification, the first input of the operational amplifier is connected with the divider junction of a first voltage divider (RK1, RK2) and a first terminal of the voltage divider is connected with the output and a second terminal of the voltage divider (RK1, RK2) is connected with a reference potential,
- the second input of the operational amplifier is connected with the divider junction of a second voltage divider (R1, RV), and the second voltage divider is constructed as a series circuit of a first resistance (R1) connected with the signal input and a second, controllable resistance (RV) connected with the reference potential, and
- the output of the operational amplifier (V1) is connected with the signal output (UOUT),
**characterised in that**
- a setting element (STG) connected with a reference voltage (UREF) is connected with the output of the operational amplifier (V1),
- the setting element (STG) is connected with the control input (G) of the second resistance (RV) and
- the setting element (STG) has a data output (DATA) connected with the processor unit (PC) and a timing input (CLK) connected with the processor unit (PC).

7. Circuit arrangement according to claim 6, **characterised in that** the controllable resistance (RV) is formed from at least two parallel circuit branches and each circuit branch is executed as a series circuit from a resistance (R1 - RN) and a controllable switching element (T1 - TN), and the control input of each switching element (T1 - TN) is connected with a respective control output (G1 - GN) of the setting element (STG).

8. Circuit arrangement according to claim 6, **characterised in that** the controllable resistance (RV) is formed from at least two parallel circuit branches and each circuit branch is executed as a transistor (T1 - TN), and the control input of each transistor (T1 - TN) is connected with a respective control output (G1 - GN) of the setting element (STG).

9. Circuit arrangement according to claim 6, **characterised in that** the controllable resistance (RV) is formed from at least two parallel circuit branches and each of the circuit branches is executed as a series circuit of a controllable current source (I1 - IN) and a controllable switching element (T1 - TN), and the control input of each switching element (T1 - TN) is connected with a respective control output (G1 - GN) of the setting element (STG).

10. Circuit arrangement according to claim 7 or claim 9, **characterised in that** the switching element (T1 - TN) is constructed as a transistor, preferably as an MOS transistor.

## Revendications

1. Méthode pour détecter l'intensité d'un champ magnétique au moyen d'une unité de réception (SE1) à partir d'un signal électromagnétique reçu, dans laquelle on génère dans l'unité de réception à partir du signal reçu (UIN) au moyen d'une résistance de réception (RI) une tension d'entrée (IN) pour un amplificateur opérationnel (V1) présentant un coefficient d'amplification constant, et l'on détermine le rapport entre la tension d'entrée (IN) et la tension de sortie (UOUT),
**caractérisée en ce que** :
• l'on compare la tension de sortie (UOUT) de l'amplificateur opérationnel (V1) à une tension de référence (UREF), et
• l'on modifie la tension d'entrée (IN) de l'amplificateur opérationnel (V1) au moyen d'une modification de la résistance d'entrée (RI) jusqu'à ce que la tension de sortie (UOUT) soit située dans un intervalle prédéfini comprenant la valeur de la tension de référence (UREF), et
• l'on associe au signal reçu une valeur d'intensité de champ magnétique par la comparaison de la valeur de la résistance d'entrée (RI) modifiée à des valeurs stockées dans un champ de valeurs.

2. Méthode selon la revendication 1, **caractérisée en ce que** l'on modifie la résistance d'entrée (RI) par étapes discrètes.

3. Méthode selon la revendication 1 ou 2, **caractérisée en ce que** la tension d'entrée (IN) est acheminée à l'amplificateur opérationnel (V1) par un noeud diviseur (K1) de la résistance d'entrée (RI) conformée en diviseur de tension.

4. Méthode selon la revendication 3, **caractérisée en ce que** l'on modifie la valeur de résistance de la partie (RV) du diviseur de tension portée à un potentiel de référence.

5. Utilisation de la méthode selon l'une quelconque des revendications 1 à 4 pour déterminer la distance spatiale entre l'unité réceptrice et l'unité émettrice.

6. Circuit pour réaliser la méthode selon l'une quelconque des revendications 1 à 4 comprenant une entrée de signal (UIN) et une sortie de signal (UOUT), un amplificateur opérationnel (V1) présentant une première entrée, une deuxième entrée et une sortie, une unité de traitement (PC) et une unité mémoire (M1) reliée à l'unité de traitement (PC), dans lequel :
• pour déterminer l'amplification, la première entrée de l'amplificateur opérationnel est reliée au noeud diviseur d'un premier diviseur de tension (RK1, RK2) et une première connexion du diviseur de tension est reliée à la sortie et une deuxième connexion du diviseur de tension (RK1, RK2) est portée à un potentiel de référence,
• la deuxième entrée de l'amplificateur opérationnel est reliée au noeud diviseur d'un deuxième diviseur de tension (R1,RV) et le deuxième diviseur de tension est monté en série avec une première résistance (R1) reliée à l'entrée de signal et d'une deuxième résistance (RV) réglable portée au potentiel de référence,
• la sortie de l'amplificateur opérationnel (V1) est reliée à la sortie de signal (UOUT),
**caractérisé en ce que** :
• un organe de réglage (STG) porté à la tension de référence (UREF) est relié à la sortie de l'amplificateur d'opération (V1), et
• l'organe de réglage (STG) est relié à l'entrée de commande (G) de la deuxième résistance (RV), et
• l'organe de réglage (STG) présente une sortie de données (DATA) reliée à l'unité de traitement (PC) et une entrée d'impulsions (CLK) reliée à l'unité de traitement (PC).

7. Circuit selon la revendication 6, **caractérisé en ce que** la résistance (RV) réglable est constituée par au moins deux branches parallèles de circuit et **en ce que** chaque branche de circuit est montée en série avec une résistance (R1-RN) et un élément de circuit (T1-TN) réglable, et **en ce que** l'entrée de commande de chaque élément de circuit (T1-TN) est reliée avec respectivement une sortie de commande (G1-GN) de l'organe de réglage (STG).

8. Circuit selon la revendication 6, **caractérisé en ce que** la résistance (RV) réglable consiste en au moins deux branches de circuit parallèles et que chaque branche de circuit comporte un transistor (T1-TN), et **en ce que** l'entrée de commande de chacun des transistors (T1-TN) est reliée à chaque fois à une sortie de réglage (G1-GN) de l'organe de réglage (STG).

9. Circuit selon la revendication 6, **caractérisé en ce que** la résistance (RV) réglable consiste en au moins deux branches de circuit parallèles et **en ce que** chaque branche de circuit est montée en série avec une source de courant (I1-IN) réglable et un élément de circuit (T1-TN) réglable, et **en ce que** l'entrée de commande de chacun des éléments de circuit (T1-TN) est reliée à chaque fois à une sortie de commande (G1-GN) de l'élément de réglage (STG).

10. Circuit selon la revendication 7 ou 9, **caractérisé en ce que** l'élément de circuit (T1-TN) est un transistor, de préférence un transistor MOS.
